# FASCICULE DE BREVET EUROPEEN

(11) **EP 4 169 137 B1**
(45) Date de publication et mention de la délivrance du brevet: **23.10.2024**
(21) Numéro de dépôt: 21734341.7
(22) Date de dépôt: 22.06.2021
(51) Int. Cl.: H02H 3/33, H02H 3/52

(54) **PROCÉDÉ DE DÉTECTION DE COURANTS DE FUITE OU DE DÉFAUT DANS UNE INSTALLATION ÉLECTRIQUE À PARTIR D'UN APPAREIL DE PROTECTION ASSURANT AU MOINS UNE PROTECTION DIFFÉRENTIELLE ET UN TEL APPAREIL CONVENANT À LA MISE EN OEUVRE DUDIT PROCÉDÉ**
VERFAHREN ZUR ERKENNUNG VON LECK- ODER FEHLERSTRÖMEN IN EINER ELEKTRISCHEN ANLAGE MIT EINER SCHUTZVORRICHTUNG
METHOD FOR DETECTING LEAKAGE OR FAULT CURRENTS IN AN ELECTRICAL INSTALLATION USING A PROTECTIVE DEVICE PROVIDING AT LEAST DIFFERENTIAL PROTECTION AND SUCH A DEVICE SUITABLE FOR IMPLEMENTING THE METHOD

(30) Priorité: 23.06.2020 FR 2006547
(43) Date de publication de la demande: 26.04.2023
(73) Titulaire: HAGER-ELECTRO SAS, 67210 Obernai (FR)
(72) Inventeur: DOLISY, Bastien, 67210 Obernai (FR); JOYEUX, Patrice, 67140 Heiligenstein (FR); SCHNEIDER, Michel, 67560 Rosheim (FR)
(74) Mandataire: Cabinet Nuss
(86) Numéro de dépôt international: PCT/EP2021/066976
(87) Numéro de publication internationale: WO 2021/259922

(56) Documents cités:
- EP-A1- 3 232 526
- EP-B1- 3 232 526
- WO-A1-2019/091740
- US-A1- 2004 145 841
- US-A1- 2018 131 173

## Description

La présente invention concerne le domaine des circuits de protection de sécurité, plus particulièrement le domaine des appareils de protection assurant au moins une protection différentielle, tels que les interrupteurs différentiels, dans une installation électrique et utilisant des détecteurs de courant électrique fonctionnant avec un tore et a pour objet un procédé de détection de courant de fuite ou de défaut dans une installation électrique à partir d'un appareil de protection assurant au moins une protection différentielle et un tel appareil convenant à la mise en oeuvre dudit procédé.

Les appareils de protection actuels assurant au moins une protection différentielle sont installés dans des installations électriques domestiques ou tertiaires alimentées par un réseau alternatif ou continu et ont pour but d'assurer principalement la sécurité des personnes en détectant le plus rapidement possible un courant de défaut représentatif d'une fuite éventuelle vers la terre dans un des circuits ou récepteurs à protéger de l'installation électrique.

De telles fuites sont par exemple causées par des contacts directs des personnes avec un conducteur électrique non isolé ou des contacts indirects dus à des défauts de masse. Ces incidents électriques sont susceptibles de générer des accidents, parfois mortels, des détériorations de matériel(s), des départs d'incendie, des dysfonctionnements localisés ou généralisés ou analogues.

Dans ces appareils de protection, la détection d'un courant de fuite ou de défaut est utilisée pour commander directement, ou à travers une électronique dédiée (étages de traitement des signaux), un actionneur ou analogue (par exemple de type relais) qui commande à son tour un mécanisme de déclenchement, de coupure ou d'ouverture associé, ou ceux d'autres appareils de protection de l'installation.

La protection différentielle nécessite l'utilisation d'un capteur fiable, économique et peu sensible aux perturbations pouvant entraîner des déclenchements intempestifs. Un circuit magnétique torique comprenant un tore traversé par, ou entourant, des conducteurs électrique alimentant l'installation électrique est une solution connue utilisée par les appareils de protection actuels car il permet de mesurer le déséquilibre des courants d'entrée et de sortie d'un circuit de façon intrinsèque (théorème d'ampère) et isolée galvaniquement. Les conducteurs traversant le tore forment le primaire. Le tore comporte un ou plusieurs enroulement(s) ou bobinage(s) secondaire(s) formant un ou plusieurs enroulements de mesure et joue le rôle d'un concentrateur de flux magnétique. Ainsi en cas de fuite, se traduisant par un déséquilibre des courants d'entrée et de sortie dans lesdits conducteurs, le flux, créé dans le tore par ce déséquilibre au niveau du primaire, induit dans le bobinage secondaire, ou enroulement de mesure, une tension qui constitue un signal de détection du courant, le cas échéant image, ou représentatif, d'un courant de défaut.

Ces appareils comprennent en outre une unité de traitement et de commande électronique permettant de traiter le signal de détection du courant en le comparant à un seuil de référence et, en fonction du résultat de la comparaison, de déclencher l'appareil en commandant des moyens de coupure ou d'ouverture interrompant la circulation du courant dans le ou les conducteurs concernés.

Pour ce qui concerne la détection des courants de fuite ou de défaut, continus, lorsque le tore de mesure est traversé par un tel courant, le champ magnétique reste constant et aucune tension induite n'est mesurable ou détectable. Pour résoudre ce problème, les appareils de protection comprennent en outre un générateur de porteuse permettant d'exciter le tore de mesure, généralement un tore magnétique doux, au moyen d'une tension de quelques centaines d'hertz à plusieurs kilohertz générée par ledit générateur de porteuse. L'amplitude du courant ou de la tension d'excitation doit être suffisamment élevée pour mettre le tore en saturation de manière symétrique.

Le document WO19091740 a pour objet un tel dispositif de protection différentielle permettant la détection de courants de fuite ou de défaut dans une installation électrique alimentée soit par au moins deux conducteurs de phase d'un réseau, soit par au moins un conducteur de phase d'un réseau et par un conducteur de neutre dudit réseau. Ledit dispositif comprend au moins un module de détection et de commande qui est fonctionnellement actif ou opérationnel pour des fréquences du signal de défaut de 0Hz à quelques dizaines de Hz. Le module est alimenté par le réseau et comprend, d'une part, un tore de mesure en un matériau ferromagnétique traversé par lesdits conducteurs, et, d'autre part, un circuit d'excitation du tore comportant un générateur de signaux alternatifs produisant une porteuse périodique, et, enfin, un enroulement de mesure apte et destiné à générer un signal de défaut (signal de mesure alternatif) résultant de l'apparition d'un défaut différentiel au niveau du réseau, ledit enroulement de mesure étant relié à des circuits de traitement et d'évaluation du signal de défaut et d'émission d'un signal de commande pour un moyen de coupure ou d'ouverture, faisant également partie du dispositif de protection différentielle. Lesdits circuits forment alors les composantes d'une chaîne électronique opérationnelle appartenant audit module. En outre, ces circuits comprennent au moins, d'une part, un circuit fournissant un signal correspondant à la valeur moyenne redressée du signal de défaut, ou d'un signal dérivé directement dépendant de ce dernier, et, d'autre part, un circuit comparant ledit signal moyen redressé à une valeur seuil prédéterminée ou préréglée et délivrant conditionnellement ou sélectivement un signal de commande du moyen de coupure ou d'ouverture, en fonction du résultat de ladite comparaison.

Toutefois, si le dispositif de protection différentielle du document WO19091740 permet de détecter des courants de fuite ou de défaut, continus, et répond aux normes de la protection différentielle telles que celles relatives à la classe de type B permettant de détecter des courants continus résiduels lisses et des courants alternatifs haute fréquence, il ne permet pas, sans modifications importantes, de mesurer des courants faibles, notamment inférieurs à 15 mA. Ce dispositif ne permet donc pas de respecter la norme de la classe de type EV qui impose que le dispositif de protection différentielle déclenche entre 3 et 6 mA. En effet, le tore utilisé dans ce type de dispositif présente des dispersions dans le comportement du matériau magnétique du tore de sorte qu'un dispositif du type de celui divulgué dans ce document est dépendant des caractéristiques du tore limitant d'autant sa sensibilité aux courants faibles. Il est également dépendant des variations dues aux conditions d'utilisation (températures et champ magnétiques extérieur).

Une solution pour permettre à ce type de dispositif divulgué par le document WO19091740 de respecter ces normes et de répondre à ce problème de dispersion pourrait être de modifier la calibration du dispositif ou de changer les composants, voire d'augmenter la taille du tore. Toutefois, ces modifications ou adaptations entraîneraient une augmentation notable du prix de revient du dispositif et, le cas échéant, une augmentation de son volume et donc de son encombrement, ce qui irait à l'encontre des objectifs que veulent atteindre les constructeurs actuellement. EP 3 232 526 décrit un dispositif de détection d'un courant de défaut circulant dans une ligne de courant.

La présente invention a pour but de pallier ces inconvénients, tout en permettant d'obtenir un appareil de volume ou d'encombrement inférieur à celui d'un dispositif du type de celui décrit dans le document WO19091740.

A cet effet, le procédé de détection de courants de fuite ou de défaut, selon la présente invention, dans une installation électrique à partir d'un appareil de protection assurant au moins une protection différentielle, ladite installation électrique étant alimentée par un courant circulant dans au moins deux conducteurs d'un réseau alternatif ou continu, ledit appareil de protection comprenant au moins un module de détection, de traitement et de commande comprenant, d'une part, un détecteur torique apte à générer en sortie un signal de mesure alternatif et comprenant un tore traversé par lesdits conducteurs et muni d'un enroulement de mesure et une source de tension ou de courant alternative apte à générer un signal d'excitation alternatif pour saturer le tore, le cas échéant ledit détecteur torique comprenant une résistance en série avec ledit tore, une unité de traitement et de commande connectée à la sortie du détecteur torique et apte à traiter le signal de mesure alternatif pour détecter un courant de fuite ou de défaut dans le réseau et à émettre, en fonction du résultat du traitement, un signal de commande pour un moyen de commande de coupure ou d'ouverture que comprend en outre ledit appareil de protection, se caractérise essentiellement en ce qu'il consiste à détecter une dissymétrie du signal de mesure alternatif entre son alternance, ou demi-période, positive et son alternance, ou demi-période, négative générée par la présence d'harmoniques de rang pair dans ledit signal de mesure alternatif représentatifs d'un courant continu relatif à un courant de fuite ou de défaut survenant dans le réseau :
- soit en déterminant par analyse fréquentielle du signal de mesure alternatif, une valeur de mesure représentative de l'apparition d'harmoniques de rang pair dans ledit signal de mesure alternatif, puis en comparant ladite valeur de mesure avec un seuil de référence pour émettre, selon le résultat de la comparaison, le signal de commande,
- soit en mesurant une première valeur d'une grandeur physique du signal de mesure alternatif dans son alternance, ou demi-période, positive et une deuxième valeur de ladite grandeur physique dans son alternance, ou demi-période, négative, puis en déterminant la différence entre lesdites première et deuxième valeurs et en comparant cette différence avec un seuil de référence pour émettre, selon le résultat de la comparaison, le signal de commande.

La présente invention a également pour objet un appareil de protection assurant au moins une protection différentielle contre les courants de fuite ou de défaut dans une installation électrique, ladite installation électrique étant alimentée par un courant circulant dans au moins deux conducteurs d'un réseau alternatif ou continu, ledit appareil de protection convenant à la mise oeuvre du procédé selon la présente invention et au moins un module de détection, de traitement et de commande comprenant, d'une part, un détecteur torique apte à générer en sortie un signal de mesure alternatif et comprenant un tore traversé par lesdits conducteurs et muni d'un enroulement de mesure et une source de tension ou de courant alternative apte à générer un signal d'excitation alternatif pour saturer le tore, le cas échéant ledit détecteur torique comprenant une résistance en série avec ledit tore, une unité de traitement et de commande connectée à la sortie du détecteur torique et apte à traiter le signal de mesure alternatif pour détecter un courant de fuite ou de défaut dans le réseau et à émettre, en fonction du résultat du traitement, un signal de commande pour un moyen de coupure ou d'ouverture que comprend en outre ledit appareil de protection, se caractérisant essentiellement en ce que l'unité de traitement et de commande est configurée pour détecter une dissymétrie du signal de mesure alternatif entre son alternance, ou demi-période, positive et son alternance, ou demi-période, négative générée par la présence d'harmoniques de rang pair dans ledit signal de mesure alternatif représentatifs d'un courant continu relatif à un courant de fuite ou de défaut survenant dans le réseau en déterminant :
- soit en déterminant, par analyse fréquentielle du signal de mesure alternatif, une valeur de mesure représentative de l'apparition d'harmoniques de rang pair dans ledit signal de mesure alternatif, puis en comparant ladite valeur de mesure avec un seuil de référence pour émettre, selon le résultat de la comparaison, le signal de commande,
- soit en mesurant une première valeur d'une grandeur physique du signal de mesure alternatif dans son alternance, ou demi-période, positive et une deuxième valeur de ladite grandeur physique dans son alternance, ou demi-période, négative puis en effectuant la différence entre lesdites première et deuxième valeurs et en comparant cette différence avec un seuil de référence pour émettre, selon le résultat de la comparaison, le signal de commande.

L'invention sera mieux comprise, grâce à la description ci-après, qui se rapporte à un mode de réalisation préféré, donné à titre d'exemple non limitatif, et expliqué avec référence aux dessins schématiques annexés, dans lesquels :

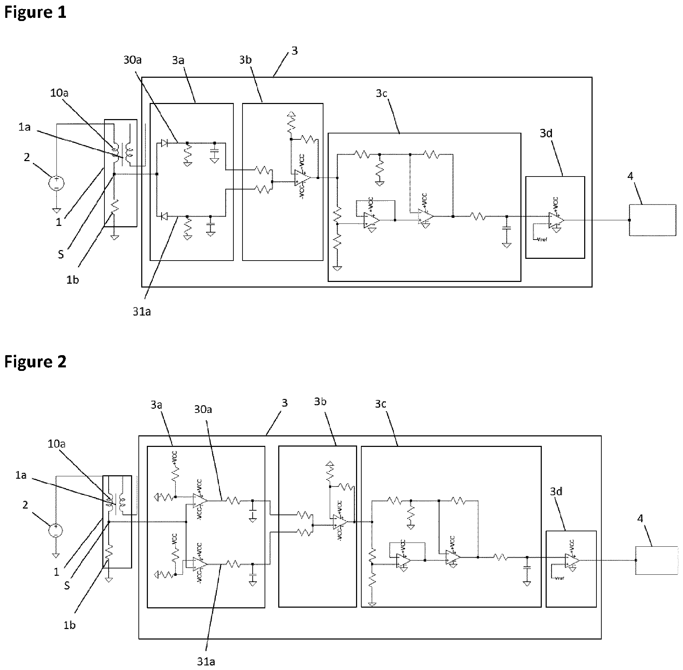

[Fig. 1] représente le schéma électrique du module de détection, de traitement et de commande d'un appareil de protection selon la présente invention convenant à la mise en oeuvre du procédé de détection selon la présente invention, dans une forme de réalisation analogique de l'unité de traitement et de commande dudit module et dans une configuration de ladite unité de traitement et de commande permettant de détecter une dissymétrie du signal de mesure alternatif entre son alternance, ou demi-période, positive et son alternance, ou demi-période, négative par détection d'une dissymétrie d'amplitude entre lesdites alternances, ou demi-périodes,
Fig. 2] représente le schéma électrique du module de détection, de traitement et de commande d'un appareil de protection selon la présente invention convenant à la mise en oeuvre du procédé de détection selon la présente invention, dans une forme de réalisation analogique de l'unité de traitement et de commande dudit module et dans une configuration de ladite unité de traitement et de commande permettant de détecter une dissymétrie du signal de mesure alternatif entre son alternance, ou demi-période, positive et son alternance, ou demi-période, négative par détection d'une dissymétrie de saturation entre lesdites alternances, ou demi-périodes,

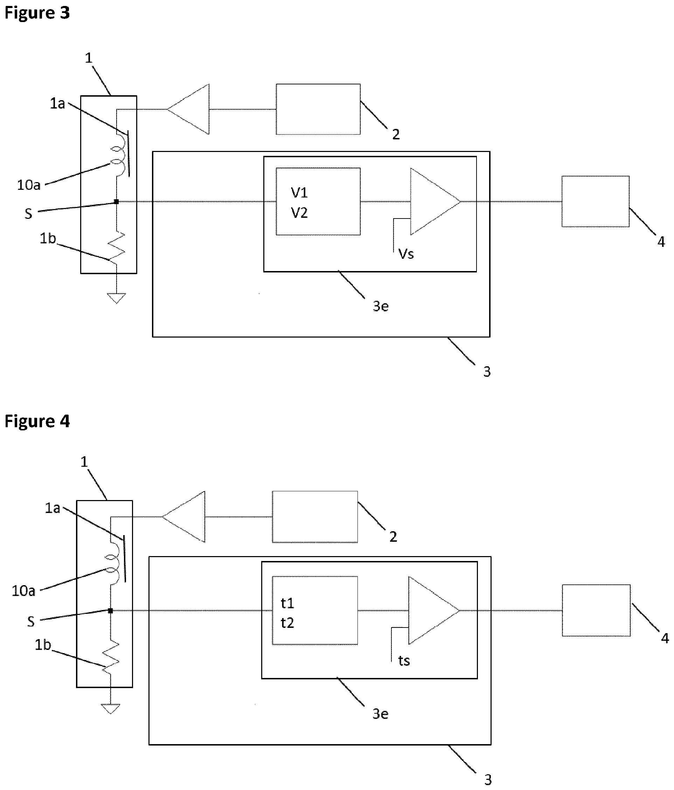

[Fig. 3] représente le schéma électrique du module de détection, de traitement et de commande d'un appareil de protection selon la présente invention convenant à la mise en oeuvre du procédé de détection selon la présente invention, dans une forme de réalisation numérique de l'unité de traitement et de commande dudit module et dans une configuration de ladite unité de traitement et de commande permettant de détecter une dissymétrie du signal de mesure alternatif entre son alternance, ou demi-période, positive et son alternance, ou demi-période, négative par détection d'une dissymétrie d'amplitude entre lesdites alternances, ou demi-périodes,
[Fig. 4] représente le schéma électrique du module de détection, de traitement et de commande d'un appareil de protection selon la présente invention convenant à la mise en oeuvre du procédé de détection selon la présente invention, dans une forme de réalisation numérique de l'unité de traitement et de commande dudit module et une configuration de ladite unité de traitement et de commande permettant de détecter une dissymétrie du signal de mesure alternatif entre son alternance, ou demi-période, positive et son alternance, ou demi-période, négative par détection d'une dissymétrie de saturation entre lesdites alternances, ou demi-périodes,

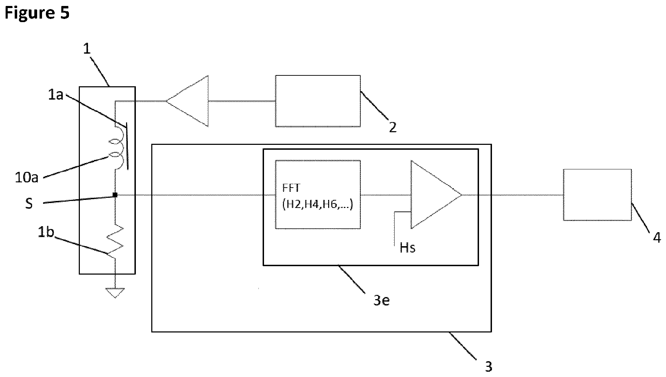

[Fig. 5] représente le schéma électrique du module de détection, de traitement et de commande d'un appareil de protection selon la présente invention convenant à la mise en oeuvre du procédé de détection selon la présente invention, dans une forme de réalisation numérique de l'unité de traitement et de commande dudit module et une configuration de ladite unité de traitement et de commande pour détecter une dissymétrie du signal de mesure alternatif entre son alternance, ou demi-période, positive et son alternance, ou demi-période, négative par analyse fréquentielle dudit signal,

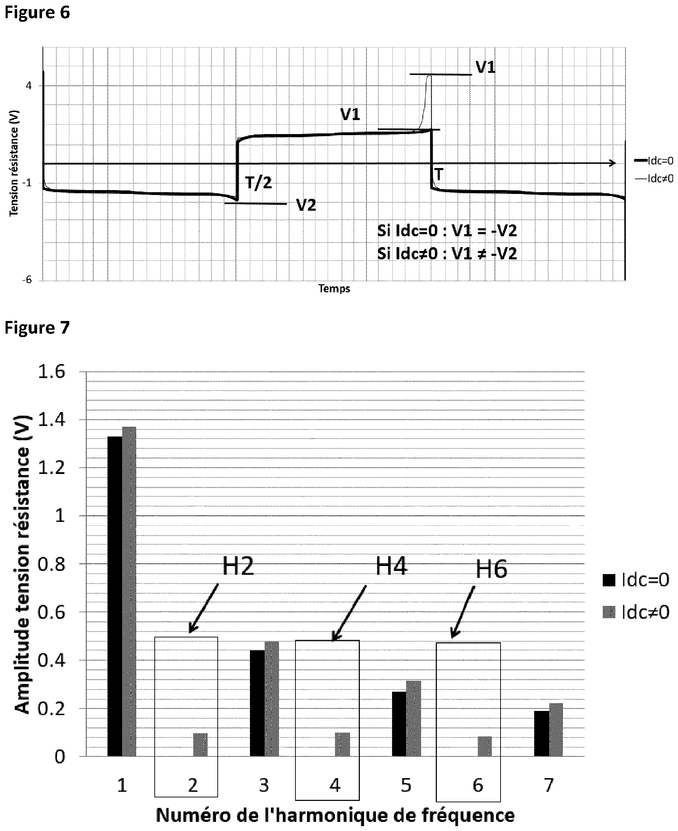

[Fig. 6] représente un signal de mesure alternatif généré par le détecteur torique et traité par l'unité de traitement et de commande du module représenté sur la figure 1 et sur la figure 3,
[Fig. 7] représente le spectre fréquentiel du signal de mesure alternatif représenté sur la figure 6, ledit spectre étant traité par l'unité de traitement et de commande du module représenté sur la figure 5,

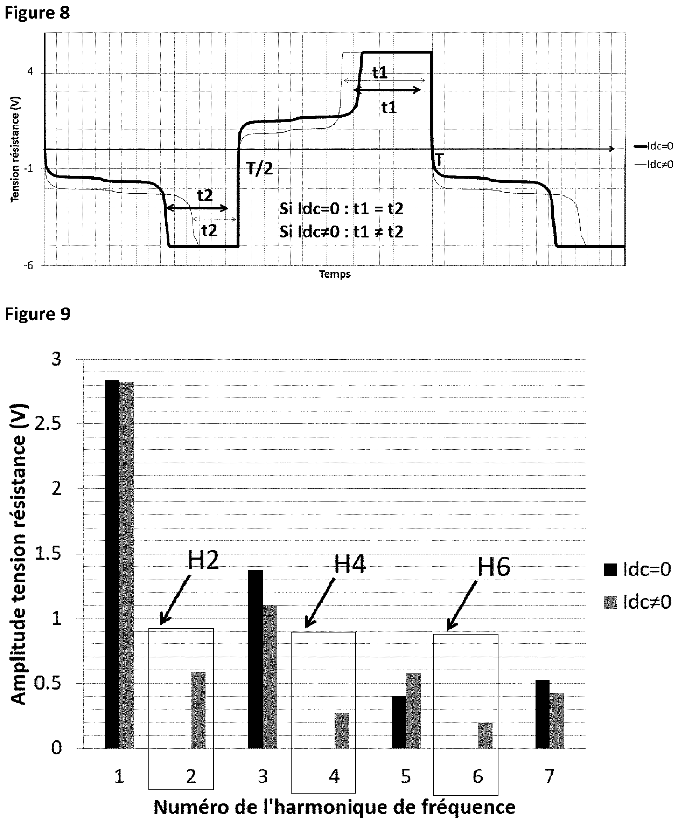

[Fig. 8] représente un signal de mesure alternatif avec un niveau de saturation élevé supérieure à celui du signal de mesure alternatif représenté sur la figure 6 et traité par l'unité de traitement et de commande du module représenté sur la figure 2 ou sur la figure 4,
[Fig. 9] représente le spectre fréquentiel du signal de mesure alternatif représenté sur la figure 8, ledit spectre étant traité par l'unité de traitement et de commande du module représenté sur la figure 5.

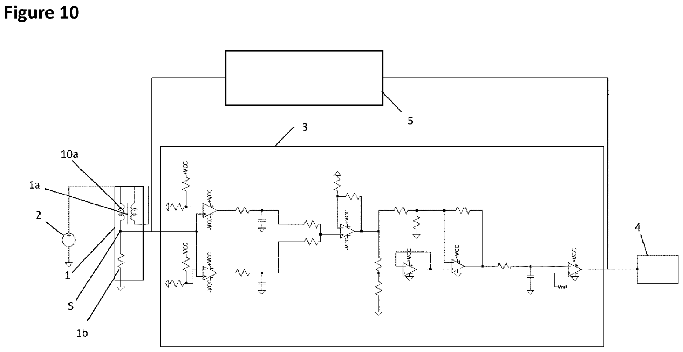

[Fig. 10] représente le schéma électrique du module de détection, de traitement et de commande d'un appareil de protection selon la présente invention, qui comprend en outre une unité de traitement et de commande additionnelle mise en parallèle de l'unité de traitement et de commande représentée sur la figure 2.

Les figures montrent un appareil de protection assurant au moins une protection différentielle contre les courants de fuite ou de défaut dans une installation électrique, ladite installation électrique étant alimentée par un courant circulant dans au moins deux conducteurs d'un réseau alternatif ou continu. Un tel appareil de protection convient à la mise en oeuvre du procédé selon la présente invention et comprend au moins un module de détection, de traitement et de commande comprenant :
- un détecteur torique 1 apte à générer en sortie S un signal de mesure alternatif et comprenant un tore 1a traversé par lesdits conducteurs et muni d'un enroulement de mesure 10a,
- une source de tension ou de courant alternative 2 apte à générer un signal d'excitation alternatif pour saturer le tore 1a, le cas échéant ledit détecteur torique 1 comprenant une résistance 1b en série avec ledit tore 1a, ladite résistance pouvant alors former aux bornes de ladite résistance la sortie S du détecteur torique 1,
- une unité de traitement et de commande 3, analogique et/ou numérique, connectée à la sortie S du détecteur torique et apte à traiter le signal de mesure alternatif en vue de détecter un courant de défaut dans le réseau et à émettre, en fonction du résultat du traitement, un signal de commande pour un moyen de commande 4 de coupure ou d'ouverture, par exemple du type relais ou autre actionneur, que comprend en outre ledit appareil de protection.

Conformément à la présente invention, un tel appareil est caractérisé en ce que l'unité de traitement et de commande 3 est configurée pour détecter une dissymétrie du signal de mesure alternatif entre son alternance, ou demi-période, positive et son alternance, ou demi-période, négative générée par la présence d'harmoniques de rang pair H2, H4, H6 dans ledit signal de mesure alternatif représentatifs d'un courant continu Idc relatif à un courant de défaut survenant dans le réseau :
- soit en déterminant par analyse fréquentielle du signal de mesure alternatif, une valeur de mesure représentative de l'apparition d'harmoniques de rang pair H2, H4, H6 dans ledit signal de mesure alternatif, puis en comparant ladite valeur de mesure avec le seuil Hs de référence pour émettre, selon le résultat de la comparaison, le signal de commande,
- soit en mesurant une première valeur V1, t1 d'une grandeur physique du signal de mesure alternatif dans son alternance, ou demi-période T/2, positive et une deuxième valeur V2, t2 de ladite grandeur physique dans son alternance, ou demi-période T/2, négative, puis en déterminant la différence entre ladite première valeur V1, t1 et ladite deuxième valeur V2, t2 et en comparant cette différence avec le seuil Vs, ts de référence pour émettre, selon le résultat de la comparaison, le signal de commande.

De manière à pouvoir mesurer la première valeur V1 et la deuxième valeur V2, dans un premier mode de réalisation (figures 1 et 3), l'unité de traitement et de commande 3 est configurée pour détecter une dissymétrie d'amplitude en mesurant l'amplitude maximale de l'alternance, ou demi-période T/2, positive du signal de mesure alternatif et l'amplitude minimale de son alternance, ou demi-période T/2, négative, la première valeur V1 étant ladite amplitude maximale et la deuxième valeur V2 étant ladite amplitude minimale.

Dans ce premier mode de réalisation, et en se référant à la figure 6, on comprendra que, lorsqu'un courant de fuite ou de défaut provenant du réseau est détecté par le détecteur torique 1, un pic d'amplitude, formant l'amplitude maximale ou minimale, dans l'une des alternances, ou demi-périodes T/2, du signal de mesure alternatif est accentué par rapport au pic d'amplitude de l'autre alternance, ou demi-période T/2. Cette différence est proportionnelle à la valeur du courant détecté par le détecteur torique 1.

On peut voir plus particulièrement sur la figure 1 que, dans une première forme de réalisation de l'unité de traitement et de commande 3 dans le premier mode de réalisation, celle-ci est configurée électroniquement de manière analogique et comprend au moins les circuits suivants montés électriquement en série :
- un circuit de mesure 3a analogique connecté à la sortie S du détecteur torique 1 et constitué de deux branches 30a, 31a connectées en parallèle, à savoir une première branche 30a apte à mesurer la première valeur V1 et une deuxième branche 31a apte à mesurer la deuxième valeur V2,
- un circuit sommateur/soustracteur 3b analogique connecté en sortie dudit circuit de mesure 3a et apte à déterminer la différence entre lesdites première et deuxième valeurs V1, V2,
- un circuit moyenneur et/ou redresseur et/ou de filtrage 3c connecté en sortie dudit circuit sommateur/soustracteur 3b, et
- un circuit comparateur et déclencheur 3d connecté en sortie dudit circuit moyenneur et/ou redresseur et/ou de filtrage 3c et apte à effectuer la comparaison entre ladite différence et le seuil Vs de référence pour émettre, selon le résultat de la comparaison, le signal de commande.

Si on se réfère à la figure 3, on peut voir que, dans une deuxième forme de réalisation de l'unité de traitement et de commande 3 dans le premier mode de réalisation précité, celle-ci est configurée électroniquement de manière numérique et consiste en un circuit de traitement et de commande à base de microprocesseur, ou microcontrôleur, 3e apte à exécuter les instructions d'un programme de traitement chargé dans une mémoire de ladite unité de traitement et de commande 3 pour mesurer la première valeur V1 et la deuxième valeur V2 puis pour effectuer la différence entre lesdites première et deuxième valeurs V1, V2 et comparer cette différence avec le seuil Vs de référence.

De manière à pouvoir mesurer la première valeur V1 et la deuxième valeur V2, dans un deuxième mode de réalisation, la source de tension ou de courant alternative 2 est configurée pour générer un signal d'excitation avec un niveau d'intensité créant dans chaque alternance, ou demi-période T/2, positive ou négative du signal de mesure alternatif une saturation de son amplitude maximale ou minimale sur une durée mesurable. En outre, comme on peut le voir sur les figures 2 et 4, l'unité de traitement et de commande 3 est configurée, pour pouvoir mesurer la première valeur t1 et la deuxième valeur t2, pour détecter une dissymétrie de saturation dans le signal de mesure alternatif en mesurant une première durée de saturation de l'amplitude maximale du signal de mesure alternatif dans son alternance, ou demi-période T/2, positive et une deuxième durée de saturation de l'amplitude minimale du signal de mesure alternatif dans son alternance, ou demi-période T/2, négative. La première valeur t1 est/correspond à ladite première durée de saturation et la deuxième valeur t2 est/correspond à ladite deuxième durée de saturation.

Dans ce deuxième mode de réalisation, on comprendra que la durée de saturation représente le temps pendant lequel le tore 1a est fortement saturé, c'est-à-dire saturé à un niveau supérieur au niveau d'excitation du tore 1a dans le premier mode de réalisation précité. Ainsi quand un courant de fuite ou de défaut provenant du réseau est détecté par le détecteur torique 1, la durée de saturation signal de mesure alternatif est différente entre celle mesurée dans son alternance, ou demi-période T/2, positive et celle mesurée dans son alternance, ou demi-période T/2, négative. Cette différence est proportionnelle à l'amplitude du courant détecté par le détecteur torique 1.

On peut voir plus particulièrement sur la figure 2 que, dans une première forme de réalisation de l'unité de traitement et de commande 3 dans le deuxième mode de réalisation, celle-ci est configurée de manière analogique et comprend au moins les circuits, de préférence à base d'amplificateur(s) opérationnel(s), suivants montés électriquement en série :
- un circuit de mesure 3a analogique connecté à la sortie S du détecteur torique 1 et constitué de deux branches 30a, 31a connectées en parallèle, à savoir une première branche 30a apte à déterminer la première valeur t1 et une deuxième branche de détection 31a apte à détecter la deuxième valeur t2,
- un circuit sommateur/soustracteur 3b analogique connecté en sortie dudit circuit de détection 3a et apte à effectuer la différence entre lesdites première et deuxième valeurs t1, t2,
- un circuit moyenneur et/ou redresseur et/ou de filtrage 3c connecté en sortie dudit circuit sommateur/soustracteur 3b et
- un circuit comparateur et déclencheur 3d connecté en sortie dudit circuit moyenneur et redresseur et/ou de filtrage 3c et apte à effectuer la comparaison entre cette différence et le seuil ts de référence pour émettre, selon le résultat de la comparaison, le signal de commande.

Le circuit moyenneur et/ou redresseur et/ou de filtrage 3c, dans chaque mode de réalisation précité, permet, essentiellement ou préférentiellement, de traiter le signal sortant du circuit sommateur/soustracteur 3b pour pouvoir mettre ledit signal dans un état apte à être traité par le circuit comparateur et déclencheur 3d. La partie redresseur (voir notamment les figures 1, 2 et 10) du circuit moyenneur et/ou redresseur et/ou de filtrage 3c permet au circuit comparateur et déclencheur 3d, dans sa fonction de comparateur, de toujours traiter une tension positive (ou un signal positif), ce qui évite la présence de deux circuits comparateur et déclencheur 3d, c'est-à-dire deux comparateurs, l'un pour la tension positive et l'autre pour la tension négative.

On comprend que, dans chaque mode de réalisation précité, le circuit sommateur/soustracteur 3b peut être ou un circuit soustracteur ou un circuit sommateur 3b, ce selon le signe des paramètres. Ainsi, dans le cas où la demi-période positive donne un paramètre positif alors que la demi-période négative donne un paramètre négatif, la présente invention peut prévoir un circuit sommateur 3b. En effet, la somme des deux paramètres permet d'obtenir la différence sur la valeur absolue car l'un est positif et l'autre négatif. Autrement, la présente invention peut prévoir un circuit soustracteur.

Si on se réfère à la figure 4, on peut voir que, dans une deuxième forme de réalisation de l'unité de traitement et de commande 3 dans le deuxième mode de réalisation, celle-ci est configurée électroniquement de manière numérique et consiste en un circuit de traitement et de commande 3e à base de microprocesseur, ou microcontrôleur, 3e apte à exécuter les instructions d'un programme de traitement chargé dans une mémoire de ladite unité de traitement et de commande 3 pour mesurer la première valeur t1 et la deuxième valeur t2 puis pour effectuer la différence entre lesdites première et deuxième valeurs t1, t2 et comparer cette différence avec le seuil ts de référence.

Le procédé de détection de courants de fuite ou de défaut, selon la présente invention, dans une installation électrique à partir d'un appareil de protection du type de celui décrit précédemment selon la présente invention, ladite installation électrique étant alimentée par un courant circulant dans au moins deux conducteurs d'un réseau alternatif ou continu, consiste à détecter une dissymétrie du signal de mesure alternatif entre son alternance, ou demi-période T/2, positive et son alternance, ou demi-période T/2, négative générée par la présence d'harmoniques de rang pair dans ledit signal de mesure alternatif représentatives d'un courant continu Idc relatif à un courant de défaut survenant dans le réseau :
- soit en déterminant, par analyse fréquentielle du signal de mesure alternatif, une valeur de mesure représentative de l'apparition d'harmoniques de rang pair dans ledit signal de mesure alternatif, puis en comparant ladite valeur de mesure avec le seuil de référence pour émettre, selon le résultat de la comparaison, le signal de commande,
- soit en mesurant une première valeur V1, t1 d'une grandeur physique du signal de mesure alternatif dans son alternance, ou demi-période T/2, positive et une deuxième valeur V2, t2 de ladite grandeur physique dans son alternance, ou demi-période, négative, puis en déterminant la différence entre lesdites première et deuxième valeurs V1, t1, V2, t2 et en comparant cette différence avec le seuil Vs, ts de référence pour émettre, selon le résultat de la comparaison, le signal de commande.

De manière à pouvoir mesurer la première valeur V1 et la deuxième valeur V2, dans un premier mode de réalisation du procédé (figures 1 et 3), l'unité de traitement et de commande 3 consiste, pour mesurer la première valeur V1 et la deuxième valeur V2, à détecter une dissymétrie d'amplitude dans le signal de mesure alternatif en mesurant l'amplitude maximale de son alternance, ou demi-période, positive et l'amplitude minimale de son alternance, ou demi-période, négative. La première valeur V1 est/correspond à ladite amplitude maximale et la deuxième valeur V2 est/correspond à ladite amplitude minimale.

Pour pouvoir mesurer la première valeur V1 et la deuxième valeur V2, dans un deuxième mode de réalisation du procédé (figures 2 et 4), ledit procédé consiste à générer un signal d'excitation avec un niveau d'intensité créant dans chaque alternance, ou demi-période, positive ou négative du signal de mesure alternatif une saturation de son amplitude maximale ou minimale sur une durée mesurable. En outre, pour mesurer la première valeur t1 et la deuxième valeur t2, ledit procédé consiste à détecter une dissymétrie de durée de saturation dans le signal de mesure alternatif en mesurant une première durée de saturation de l'amplitude maximale de son alternance, ou demi-période, positive et une deuxième durée de saturation de l'amplitude minimale de son alternance, ou demi-période, négative. La première valeur t1 est/correspond à ladite première durée de saturation et la deuxième valeur t2 est/correspond à ladite deuxième durée de saturation.

Concernant le choix du mode de réalisation du procédé ou de l'appareil permettant de réaliser une détection de dissymétrie d'amplitude ou de dissymétrie de saturation, ce choix dépend essentiellement du niveau de saturation du tore 1a par le signal d'excitation alternatif généré par la source de tension ou de courant alternative 2 et donc du réglage de cette dernière.

Dans le cas où la source de tension ou de courant alternative 2 est réglée de sorte à générer un signal d'excitation ayant pour effet que le tore 1a atteint un état de saturation élevée (fort courant d'excitation ou fort courant à mesurer), l'impédance du tore sera négligeable, le cas échéant comparé à la valeur de la résistance 1b montée en série avec ledit tore 1a, et la totalité de la tension de la porteuse formée par le signal d'excitation se retrouvera aux bornes de la résistance 1b. Dans ce cas, le choix du mode de réalisation pour permettre une détection de dissymétrie de saturation est privilégié.

La détection ou analyse de dissymétrie de saturation dans le signal de mesure alternatif entre ses alternances, ou demi-périodes, positive et négative réalisée dans le deuxième mode de réalisation du procédé ou de l'appareil, est plus précise que la détection ou analyse de dissymétrie d'amplitude réalisée dans le deuxième mode de réalisation du procédé ou de l'appareil, mais nécessite de saturer le tore 1a fortement, c'est-à-dire à un niveau plus élevée, voire nettement plus élevée, que celui de l'excitation du tore 1a réalisée dans le premier mode de réalisation, et donc de nécessiter une consommation énergétique plus élevée de l'électronique mise en oeuvre.

Par ailleurs, dans une forme de réalisation particulière du procédé ou de l'appareil, comme on peut le voir sur la figure 10, pour détecter des courants très élevés, la présente invention peut prévoir qu'une seconde détection soit mise en parallèle, c'est-à-dire qu'une unité de traitement et de commande additionnelle 5 soit connectée en sortie S du détecteur torique 1 et mise en parallèle de l'unité de traitement et de commande 3 quel que soit le mode de réalisation de cette dernière décrit précédemment. Une telle unité de traitement et de commande additionnelle 5 peut être basée sur le redressement et le calcul de la moyenne sans utilisation de la partie détection/analyse de dissymétrie, par analyse fréquentielle ou comparaison des alternances, ou demi-période, positive et négative du signal de mesure alternatif par l'unité de traitement et de commande 3. Une telle unité de traitement et de commande additionnelle 5 peut être du type d'une unité ou d'un circuit de traitement et de commande utilisée dans les dispositifs de protection actuels, par exemple du type du circuit de traitement de du dispositif décrit dans le document WO19091740. Cette partie de détection/analyse de dissymétrie de l'unité de traitement et de commande 3 forme en quelque sorte un filtre électronique analogique ou numérique situé dans la chaine opérationnelle.

L'unité de traitement et de commande additionnelle 5 peut comprendre des circuits en série, d'une part, un circuit 5a connecté en sortie S du détecteur torique 1 et apte à fournir un signal correspondant à la valeur moyenne redressée du signal de défaut, ou d'un signal dérivé directement dépendant de ce dernier, et, d'autre part, un circuit 5b connecté en sortie du circuit 5a et apte à comparer ledit signal moyen redressé à un seuil de référence prédéterminé ou préréglé et délivrant conditionnellement ou sélectivement un signal de commande du moyen de coupure ou d'ouverture, en fonction du résultat de ladite comparaison.

Si on se réfère à la figure 5, on peut voir que le procédé selon la présente invention peut consister, dans sa forme de réalisation déterminant la dissymétrie dans le signal de mesure alternatif par analyse fréquentielle de ce dernier, à réaliser ladite analyse fréquentielle par décomposition en série de fourrier du signal de mesure et alternatif et par comparaison de l'amplitude de tension correspondant à un harmonique de rang pair, par exemple au moins l'un des trois premiers harmoniques H2, H4, H6 avec le seuil Hs de référence. L'unité de traitement et de commande 3 de l'appareil de protection peut alors être configurée pour réaliser ladite analyse fréquentielle par décomposition en série de fourrier FFT du signal de mesure et alternatif et par comparaison de l'amplitude de tension correspondant à un harmonique de rang pair H2, H4 ou H6 avec le seuil Hs de référence.

La figure 7 montre le spectre de fréquence obtenu pour un signal de mesure alternatif du type de celui représenté sur la figure 6 et comprenant un pic d'amplitude maximale ou minimale dans chaque alternance, ou demi-période. Les harmoniques de rang pair H2, H4, H6 dans ledit spectre de fréquence sont représentatifs de la présence d'un courant continu Idc relatif à un courant de défaut survenant dans le réseau. On comprendra que les harmoniques de rang pair, pour un tel signal de mesure alternatif, peuvent être ainsi être détectés soit par la détection de dissymétrie d'amplitude décrite précédemment, soit par la l'analyse fréquentielle également décrite précédemment.

La figure 9 montre le spectre obtenu pour un signal de mesure alternatif du type de celui représenté sur la figure 8 et comprenant une durée de saturation dans chaque alternance, ou demi-période. Les harmoniques de rang pair H2, H4, H6 dans ledit spectre de fréquence, sont représentatifs de la présence d'un courant continu Idc relatif à un courant de défaut survenant dans le réseau. Dans ce cas Idc est strictement supérieur à zéro. On comprendra que les harmoniques de rang pair, pour un tel signal de mesure alternatif, peuvent être ainsi être détectés soit par la détection de dissymétrie de saturation décrite précédemment, soit par l'analyse fréquentielle également décrite précédemment.

Chaque seuil Vs, ts, Hs de référence peut être préréglée ou prédéterminée. Dans la forme analogique de l'unité de traitement et de commande 3 (figures 1 et 2), le seuil Vs, ts de référence est mémorisée par exemple par un condensateur que peut comprendre le circuit comparateur et déclencheur 3d. Dans la forme numérique de l'unité de traitement et de commande 3 (figures 3, 4 et 5), le seuil Vs, ts, Hs de référence peut être mémorisé dans une mémoire que peut comprendre l'unité de traitement et de commande 3.

Ainsi, un tel procédé et un tel appareil de protection convenant à sa mise oeuvre permettent au moins l'un des avantages suivants :
- de mesurer des courants faibles, notamment inférieurs à 30 mA, respectant les normes actuels et notamment la norme de la classe de type B imposant un déclenchement de l'appareil de protection différentiel entre 15 et 60 mA et la norme de la classe de type EV imposant un déclenchement de l'appareil de protection différentiel entre 3 et 6 mA,
- amélioration de la précision du détecteur torique en gommant la dispersion apportée en grande partie par les caractéristiques intrinsèques du tore 1a et les variations dues aux conditions d'utilisation (par exemple : températures et champ(s) magnétique(s) extérieur(s)),
- moins de contraintes sur le tore 1a (réduction du prix de revient et facilité d'approvisionnement),
- aucune calibration après le montage de l'appareil de protection,
- de mesurer et d'afficher les valeurs de courants AC et DC à l'utilisateur au moyen d'un écran intégré dans ledit appareil ou dans un autre appareil connecté à ce dernier
- encombrement ou volume réduit, notamment inférieur à celui d'un dispositif du type de celui décrit dans le document WO19091740, quel soit l'intensité du courant faible mesurée.

Bien entendu, l'invention n'est pas limitée aux modes de réalisation décrits et représentés aux dessins annexés. Des modifications restent possibles, notamment du point de vue de la constitution des divers éléments, sans sortir pour autant du domaine de protection de l'invention selon les revendications.

## Revendications

1. [Procédé de détection de courants de fuite ou de défaut dans une installation électrique à partir d'un appareil de protection assurant au moins une protection différentielle, ladite installation électrique étant alimentée par un courant circulant dans au moins deux conducteurs d'un réseau alternatif ou continu, ledit appareil de protection comprenant au moins un module de détection, de traitement et de commande comprenant, d'une part, un détecteur torique (1) apte à générer en sortie (S) un signal de mesure alternatif et comprenant un tore (1a) traversé par lesdits conducteurs et muni d'un enroulement de mesure (10a) et une source de tension ou de courant alternative (2) apte à générer un signal d'excitation alternatif pour saturer le tore (1a), le cas échéant ledit détecteur torique (1) comprenant une résistance (1b) en série avec ledit tore (1a), une unité de traitement et de commande (3) connectée à la sortie (S) du détecteur torique et apte à traiter le signal de mesure alternatif pour détecter un courant de fuite ou de défaut dans le réseau et à émettre, en fonction du résultat du traitement, un signal de commande pour un moyen de commande (4) de coupure ou d'ouverture que comprend en outre ledit appareil de protection, **caractérisé en ce qu'**il consiste à détecter une dissymétrie du signal de mesure alternatif, entre son alternance, ou demi-période, positive et son alternance, ou demi-période, négative, générée par la présence d'harmoniques de rang pair (H2, H4, H6) dans ledit signal de mesure alternatif représentatives d'un courant continu (Idc) relatif à un courant de fuite ou de défaut survenant dans le réseau :
- soit en déterminant, par analyse fréquentielle du signal de mesure alternatif, une valeur de mesure représentative de l'apparition d'harmoniques de rang pair (H2, H4, H6) dans ledit signal de mesure alternatif, puis en comparant ladite valeur de mesure avec un seuil (Hs) de référence pour émettre, selon le résultat de la comparaison, le signal de commande,
- soit en mesurant une première valeur (V1, t1) d'une grandeur physique du signal de mesure alternatif dans son alternance, ou demi-période, positive et une deuxième valeur (V2, t2) de ladite grandeur physique dans son alternance, ou demi-période, négative, puis en déterminant la différence entre lesdites première et deuxième valeurs (V1, t1, V2, t2) et en comparant cette différence avec un seuil (Vs, ts) de référence pour émettre, selon le résultat de la comparaison, le signal de commande.

2. Procédé, selon la revendication 1, **caractérisé en ce qu'**il consiste, pour mesurer la première valeur (V1) et la deuxième valeur (V2), à détecter une dissymétrie d'amplitude dans le signal de mesure alternatif en mesurant l'amplitude maximale de son alternance, ou demi-période, positive et l'amplitude minimale de son alternance, ou demi-période, négative, la première valeur (V1) étant ladite amplitude maximale et la deuxième valeur (V2) étant ladite amplitude minimale.

3. Procédé, selon la revendication 1, **caractérisé en ce que en ce qu'**il consiste à générer un signal d'excitation avec un niveau d'intensité créant dans chaque alternance, ou demi-période, positive ou négative du signal de mesure alternatif une saturation de son amplitude maximale ou minimale sur une durée mesurable et **en ce qu'**il consiste, pour mesurer la première valeur (t1) et la deuxième valeur (t2), à détecter une dissymétrie de saturation dans le signal de mesure alternatif en mesurant une première durée de saturation de l'amplitude maximale de son alternance, ou demi-période, positive et une deuxième durée de saturation de l'amplitude minimale de son alternance, ou demi-période, négative, la première valeur (t1) étant ladite première durée de saturation et la deuxième valeur (t2) étant ladite deuxième durée de saturation.

4. Procédé, selon la revendication 1, **caractérisé en ce qu'**il consiste à réaliser l'analyse fréquentielle par décomposition en série de fourrier du signal de mesure et alternatif et par comparaison de l'amplitude de tension correspondant à une harmonique de rang pair (H2, H4, H6) avec le seuil (Hs) de référence.

5. Appareil de protection assurant au moins une protection différentielle permettant la détection de courants de fuite ou de défaut dans une installation électrique, ladite installation électrique étant alimentée par un courant circulant dans au moins deux conducteurs d'un réseau alternatif ou continu, ledit appareil de protection convenant à la mise oeuvre du procédé selon l'une quelconque des revendications 1 à 4 et comprenant au moins un module de détection, de traitement et de commande comprenant, d'une part, un détecteur torique (1) apte à générer en sortie (S) un signal de mesure alternatif et comprenant un tore (1a) traversé par lesdits conducteurs et muni d'un enroulement de mesure (10a) et une source de tension ou de courant alternative (2) apte à générer un signal d'excitation alternatif pour saturer le tore (1a), le cas échéant ledit détecteur torique (1) comprenant une résistance (1b) en série avec ledit tore (1a), une unité de traitement et de commande (3) connectée à la sortie (S) du détecteur torique et apte à traiter le signal de mesure alternatif pour détecter un courant de fuite ou de défaut dans le réseau et à émettre, en fonction du résultat du traitement, un signal de commande pour un moyen de commande (4) de coupure ou d'ouverture que comprend en outre ledit appareil de protection, **caractérisé en ce que** l'unité de traitement et de commande (3) est configurée pour détecter une dissymétrie du signal de mesure alternatif entre son alternance, ou demi-période, positive et son alternance, ou demi-période, négative générée par la présence d'harmoniques de rang pair (H2, H4, H6) dans ledit signal de mesure alternatif représentatives d'un courant continu (Idc) relatif à un courant de de fuite ou de défaut survenant dans le réseau
- soit en déterminant, par analyse fréquentielle du signal de mesure alternatif, une valeur de mesure représentative de l'apparition d'harmoniques de rang pair (H2, H4, H6) dans ledit signal de mesure alternatif, puis en comparant ladite valeur de mesure avec un seuil (Hs) de référence pour émettre, selon le résultat de la comparaison, le signal de commande,
- soit en mesurant une première valeur (V1, t1) d'une grandeur physique du signal de mesure alternatif dans son alternance, ou demi-période, positive et une deuxième valeur (V2, t2) de ladite grandeur physique dans son alternance, ou demi-période, négative puis en effectuant la différence entre lesdites première et deuxième valeurs (V1, t1, V2, t2) et en comparant cette différence avec un seuil (Vs, ts) de référence pour émettre, selon le résultat de la comparaison, le signal de commande.

6. Appareil de protection, selon la revendication 5, **caractérisé en ce que**, pour pouvoir mesurer la première valeur (V1) et la deuxième valeur (V2), l'unité de traitement et de commande (3) est configurée pour détecter une dissymétrie d'amplitude en mesurant l'amplitude maximale de l'alternance, ou demi-période, positive du signal de mesure alternatif et l'amplitude minimale de son alternance, ou demi-période, négative, la première valeur (V1) étant ladite amplitude maximale et la deuxième valeur (V2) étant ladite amplitude minimale.

7. Appareil de protection, selon la revendication 6, **caractérisé en ce que** l'unité de traitement et de commande (3) est configurée électroniquement de manière analogique et **en ce qu'**elle comprend au moins les circuits suivants montés électriquement en série : un circuit de mesure (3a) analogique connecté à la sortie (S) du détecteur torique (1) et constitué de deux branches (30a, 31a) connectées en parallèle, à savoir une première branche (30a) apte à mesurer la première valeur (V1) et une deuxième branche (31a) apte à mesurer la deuxième valeur (V2), un circuit sommateur/soustracteur (3b) analogique connecté en sortie dudit circuit de mesure (3a) et apte à déterminer la différence entre lesdites première et deuxième valeurs (V1, V2), un circuit moyenneur et/ou redresseur et/ou de filtrage (3c) analogique connecté en sortie dudit circuit sommateur/soustracteur (3b) et un circuit comparateur et déclencheur (3d) analogique connecté en sortie dudit circuit moyenneur et/ou redresseur et/ou de filtrage (3c) apte à effectuer la comparaison entre ladite différence et le seuil (Vs) de référence pour émettre, selon le résultat de la comparaison, le signal de commande.

8. Appareil de protection, selon la revendication 6, **caractérisé en ce que** l'unité de traitement et de commande (3) est configurée électroniquement de manière numérique et **en ce qu'**elle consiste en un circuit de traitement et de commande à base de microprocesseur, ou microcontrôleur, (3e) apte à exécuter les instructions d'un programme de traitement chargé dans une mémoire de ladite unité de traitement et de commande (3) pour mesurer la première valeur (V1) et la deuxième valeur (V2) puis pour effectuer la différence entre lesdites première et deuxième valeurs (V1, V2) et comparer cette différence avec le seuil (Vs) de référence.

9. Appareil de protection, selon la revendication 5, **caractérisé en ce que** la source de tension ou de courant alternative (2) est configurée pour générer un signal d'excitation avec un niveau d'intensité créant dans chaque alternance, ou demi-période, positive ou négative du signal de mesure alternatif une saturation de son amplitude maximale ou minimale sur une durée mesurable et **en ce qu'**il que l'unité de traitement et de commande (3) est configurée, pour pouvoir mesurer la première valeur (t1) et la deuxième valeur (t2), pour détecter une dissymétrie de saturation dans le signal de mesure alternatif en mesurant une première durée de saturation de l'amplitude maximale de son alternance, ou demi-période, positive et une deuxième durée de saturation de l'amplitude minimale de son alternance, ou demi-période, négative, la première valeur (t1) étant ladite première durée de saturation et la deuxième valeur (t2) étant ladite deuxième durée de saturation.

10. Appareil de protection, selon la revendication 9, **caractérisé en ce que** l'unité de traitement et de commande (3) est configurée de manière analogique et comprend au moins les circuits suivants montés électriquement en série : un circuit de mesure (3a) analogique connecté à la sortie (S) du détecteur torique (1) et constitué de deux branches (30a, 31a) connectées en parallèle, à savoir une première branche (30a) apte à déterminer la première valeur (t1) et une deuxième branche (31a) apte à détecter la deuxième valeur (t2), un circuit sommateur/soustracteur (3b) analogique connecté en sortie du circuit de mesure (3a) et apte à effectuer la différence entre lesdites première et deuxième valeurs (t1, t2), un circuit moyenneur et/ou redresseur et/ou de filtrage (3c) analogique connecté en sortie du circuit sommateur/soustracteur (3b) et un circuit comparateur et déclencheur (3d) analogique connecté en sortie du circuit moyenneur et/ou redresseur et/ou de filtrage (3c) et apte à effectuer la comparaison entre cette différence et le seuil (ts) de référence pour émettre, selon le résultat de la comparaison, le signal de commande.

11. Appareil de protection, selon la revendication 9, **caractérisé en ce que** l'unité de traitement et de commande (3) est configurée électroniquement de manière numérique et **en ce qu'**elle consiste en un circuit de traitement et de commande à base de microprocesseur, ou microcontrôleur, (3e) apte à exécuter les instructions d'un programme de traitement chargé dans une mémoire de ladite unité de traitement et de commande (3) pour mesurer la première valeur (t1) et la deuxième valeur (t2) puis pour effectuer la différence entre lesdites première et deuxième valeurs (t1, t2) et comparer cette différence avec le seuil (ts) de référence.

12. Appareil de protection, selon la revendication 5, **caractérisé en ce que** l'unité de traitement et de commande (3) est configurée pour réaliser l'analyse fréquentielle par décomposition en série de fourrier du signal de mesure et alternatif et par comparaison de l'amplitude de tension correspondant à un harmonique de rang pair (H2, H4, H6) avec le seuil (hs) de référence.

## Patentansprüche

1. Verfahren zur Erkennung von Leck- oder Fehlerströmen in einer elektrischen Anlage ausgehend von einem Schutzgerät, das mindestens einen Differentialschutz gewährleistet, wobei die elektrische Anlage von einem Strom gespeist wird, der in mindestens zwei Leitern eines Wechselstrom- oder Gleichstromnetzes fließt, wobei das Schutzgerät mindestens ein Erkennungs-, Verarbeitungs-und Steuermodul enthält, das einerseits einen ringförmigen Detektor (1), der fähig ist, am Ausgang (S) ein Mess-Wechselsignal zu erzeugen und einen Ringkern (1a) enthält, der von den Leitern durchquert wird und mit einer Messwicklung (10a) versehen ist, und eine Spannungs- oder Strom-Wechselquelle (2), die fähig ist, ein Anregungs-Wechselsignal zu generieren, um den Ringkern (1a) zu sättigen, wobei ggf. der ringförmige Detektor (1) einen Widerstand (1b) in Reihe mit dem Ringkern (1a) enthält, eine Verarbeitungs- und Steuereinheit (3) enthält, die mit dem Ausgang (S) des ringförmigen Detektors verbunden und fähig ist, das Mess-Wechselsignal zu verarbeiten, um einen Leck- oder Fehlerstrom im Netz zu erkennen und um abhängig vom Ergebnis der Verarbeitung ein Steuersignal für eine Abschalt- oder Öffnungssteuereinrichtung (4) zu senden, die das Schutzgerät außerdem enthält, **dadurch gekennzeichnet, dass** es darin besteht, eine Asymmetrie des Mess-Wechselsignals zwischen seiner positiven Halbschwingung oder Halbperiode und seiner negativen Halbschwingung oder Halbperiode zu erkennen, die durch das Vorhandensein von geradzahligen Harmonischen (H2, H4, H6) im Mess-Wechselsignal generiert wird, die für einen Gleichstrom (Idc) bezüglich eines im Netz auftretenden Leck- oder Fehlerstroms repräsentativ sind:
- entweder, indem durch Frequenzanalyse des Mess-Wechselsignals ein für das Auftreten von geradzahligen Harmonischen (H2, H4, H6) im Mess-Wechselsignal repräsentativer Messwert bestimmt wird, dann, indem der Messwert mit einer Bezugsschwelle (Hs) verglichen wird, um das Steuersignal gemäß dem Ergebnis des Vergleichs zu senden,
- oder, indem ein erster Wert (V1, t1) einer physikalischen Größe des Mess-Wechselsignals in seiner positiven Halbschwingung oder Halbperiode und ein zweiter Wert (V2, t2) der physikalischen Größe in seiner negativen Halbschwingung oder Halbperiode gemessen wird, dann, indem die Differenz zwischen den ersten und zweiten Werten (V1, t1, V2, t2) bestimmt wird und indem diese Differenz mit einer Bezugsschwelle (Vs, ts) verglichen wird, um das Steuersignal gemäß dem Ergebnis des Vergleichs zu senden.

2. Verfahren nach Anspruch 1, **dadurch gekennzeichnet, dass** es zum Messen des ersten Werts (V1) und des zweiten Werts (V2) darin besteht, eine Amplitudenasymmetrie im Mess-Wechselsignal zu erkennen, indem die maximale Amplitude seiner positiven Halbschwingung oder Halbperiode und die minimale Amplitude seiner negativen Halbschwingung oder Halbperiode gemessen werden, wobei der erste Wert (V1) die maximale Amplitude und der zweite Wert (V2) die minimale Amplitude ist.

3. Verfahren nach Anspruch 1, **dadurch gekennzeichnet, dass** es darin besteht, ein Anregungssignal mit einem Stärkepegel zu generieren, der in jeder positiven oder negativen Halbschwingung oder Halbperiode des Mess-Wechselsignals eine Sättigung seiner maximalen oder minimalen Amplitude über eine messbare Dauer erzeugt, und dass es zum Messen des ersten Werts (t1) und des zweiten Werts (t2) darin besteht, eine Sättigungsasymmetrie im Mess-Wechselsignal zu erkennen, indem eine erste Sättigungsdauer der maximalen Amplitude seiner positiven Halbschwingung oder Halbperiode und eine zweite Sättigungsdauer der minimalen Amplitude seiner negativen Halbschwingung oder Halbperiode gemessen werden, wobei der erste Wert (t1) die erste Sättigungsdauer und der zweite Wert (t2) die zweite Sättigungsdauer ist.

4. Verfahren nach Anspruch 1, **dadurch gekennzeichnet, dass** es darin besteht, die Frequenzanalyse durch Zerlegung des Mess- und Wechselsignals in eine Fourier-Reihe und durch Vergleich der Spannungsamplitude entsprechend einer geradzahligen Harmonischen (H2, H4, H6) mit der Bezugsschwelle (Hs) zu realisieren.

5. Schutzgerät, das mindestens einen Differentialschutz gewährleistet, das die Erkennung von Leck- oder Fehlerströmen in einer elektrischen Anlage ermöglicht, wobei die elektrische Anlage von einem Strom gespeist wird, der in mindestens zwei Leitern eines Wechselstrom- oder Gleichstromnetzes fließt, wobei das Schutzgerät für die Durchführung des Verfahrens nach einem der Ansprüche 1 bis 4 geeignet ist und mindestens ein Erkennungs-, Verarbeitungs- und Steuermodul enthält, das einerseits einen ringförmigen Detektor (1), der fähig ist, am Ausgang (S) ein Mess-Wechselsignal zu generieren und einen Ringkern (1a) enthält, der von den Leitern durchquert wird und mit einer Messwicklung (10a) versehen ist, und eine Spannungs- oder Strom-Wechselquelle (2), die fähig ist, ein Anregungs-Wechselsignal zu generieren, um den Ringkern (1a) zu sättigen, wobei ggf. der ringförmige Detektor (1) einen Widerstand (1b) in Reihe mit dem Ringkern (1a) enthält, eine Verarbeitungs- und Steuereinheit (3) enthält, die mit dem Ausgang (S) des ringförmigen Detektors verbunden und fähig ist, das Mess-Wechselsignal zu verarbeiten, um einen Leck- oder Fehlerstrom im Netz zu erkennen und um abhängig vom Ergebnis der Verarbeitung ein Steuersignal für eine Abschalt- oder Öffnungssteuereinrichtung (4) zu senden, die das Schutzgerät außerdem enthält, **dadurch gekennzeichnet, dass** die Verarbeitungs- und Steuereinheit (3) konfiguriert ist, eine Asymmetrie des Mess-Wechselsignals zwischen seiner positiven Halbschwingung oder Halbperiode und seiner negativen Halbschwingung oder Halbperiode zu erkennen, die durch das Vorhandensein von geradzahligen Harmonischen (H2, H4, H6) im Mess-Wechselsignal generiert wird, die für einen Gleichstrom (Idc) bezüglich eines im Netz auftretenden Leck- oder Fehlerstroms repräsentativ sind:
- entweder, indem durch Frequenzanalyse des Mess-Wechselsignals ein für das Auftreten von geradzahligen Harmonischen (H2, H4, H6) im Mess-Wechselsignal repräsentativer Messwert bestimmt wird, dann, indem der Messwert mit einer Bezugsschwelle (Hs) verglichen wird, um das Steuersignal gemäß dem Ergebnis des Vergleichs zu senden,
- oder, indem ein erster Wert (V1, t1) einer physikalischen Größe des Mess-Wechselsignals in seiner positiven Halbschwingung oder Halbperiode und ein zweiter Wert (V2, t2) der physikalischen Größe in seiner negativen Halbschwingung oder Halbperiode gemessen wird, dann, indem die Differenz zwischen den ersten und zweiten Werten (V1, t1, V2, t2) ausgeführt wird, und indem diese Differenz mit einer Bezugsschwelle (Vs, ts) verglichen wird, um das Steuersignal gemäß dem Ergebnis des Vergleichs zu senden.

6. Schutzgerät nach Anspruch 5, **dadurch gekennzeichnet, dass**, um den ersten Wert (V1) und den zweiten Wert (V2) messen zu können, die Verarbeitungs-und Steuereinheit (3) konfiguriert ist, um eine Amplitudenasymmetrie zu erkennen, indem die maximale Amplitude der positiven Halbschwingung oder Halbperiode des Mess-Wechselsignals und die minimale Amplitude seiner negativen Halbschwingung oder Halbperiode gemessen werden, wobei der erste Wert (V1) die maximale Amplitude und der zweite Wert (V2) die minimale Amplitude ist.

7. Schutzgerät nach Anspruch 6, **dadurch gekennzeichnet, dass** die Verarbeitungs- und Steuereinheit (3) analog elektronisch konfiguriert ist, und dass sie mindestens die folgenden elektrisch in Reihe geschalteten Schaltungen enthält: eine analoge Messschaltung (3a), die mit dem Ausgang (S) des ringförmigen Detektors (1) verbunden ist und aus zwei parallel verbundenen Zweigen (30a, 31a) besteht, nämlich einem ersten Zweig (30a), der fähig ist, den ersten Wert (V1) zu messen, und einem zweiten Zweig (31a), der fähig ist den zweiten Wert (V2) zu messen, eine analoge Summier-/Subtrahierschaltung (3b), die mit dem Ausgang der Messschaltung (3a) verbunden und fähig ist, die Differenz zwischen den ersten und zweiten Werten (V1, V2) zu bestimmen, eine mit dem Ausgang der Summier-/Subtrahierschaltung (3b) verbundene analoge Mittelungs-und/oder Gleichrichtungs- und/oder Filterschaltung (3c), und eine mit dem Ausgang der Mittelungs- und/oder Gleichrichtungs- und/oder Filterschaltung (3c) verbundene analoge Vergleichs- und Auslöseschaltung (3d), die fähig ist, den Vergleich zwischen der Differenz und der Bezugsschwelle (Vs) auszuführen, um das Steuersignal gemäß dem Ergebnis des Vergleichs zu senden.

8. Schutzgerät nach Anspruch 6, **dadurch gekennzeichnet, dass** die Verarbeitungs- und Steuereinheit (3) digital elektronisch konfiguriert ist, und dass sie aus einer Verarbeitungs- und Steuerschaltung auf der Basis eines Mikroprozessors oder Mikrocontrollers (3e) besteht, die fähig ist, die Anweisungen eines in einen Speicher der Verarbeitungs- und Steuereinheit (3) geladenen Verarbeitungsprogramms auszuführen, um den ersten Wert (V1) und den zweiten Wert (V2) zu messen, dann, um die Differenz zwischen den ersten und zweiten Werten (V1, V2) auszuführen und diese Differenz mit der Bezugsschwelle (Vs) zu vergleichen.

9. Schutzgerät nach Anspruch 5, **dadurch gekennzeichnet, dass** die Spannungs- oder Strom-Wechselquelle (2) konfiguriert ist, ein Anregungssignal mit einem Stärkepegel zu generieren, das in jeder positiven oder negativen Halbschwingung oder Halbperiode des Mess-Wechselsignals eine Sättigung seiner maximalen oder minimalen Amplitude über eine messbare Dauer erzeugt, und dass die Verarbeitungs- und Steuereinheit (3) konfiguriert ist, um den ersten Wert (t1) und den zweiten Wert (t2) messen zu können, um eine Sättigungsasymmetrie im Mess-Wechselsignal zu erkennen, indem eine erste Sättigungsdauer der maximalen Amplitude seiner positiven Halbschwingung oder Halbperiode und eine zweite Sättigungsdauer der minimalen Amplitude seiner negativen Halbschwingung oder Halbperiode gemessen wird, wobei der erste Wert (t1) die erste Sättigungsdauer und der zweite Wert (t2) die zweite Sättigungsdauer ist.

10. Schutzgerät nach Anspruch 9, **dadurch gekennzeichnet, dass** die Verarbeitungs- und Steuereinheit (3) analog konfiguriert ist und mindestens die folgenden elektrisch in Reihe geschalteten Schaltungen enthält: eine analoge Messschaltung (3a), die mit dem Ausgang (S) des ringförmigen Detektors (1) verbunden ist und aus zwei parallel verbundenen Zweigen (30a, 31a) besteht, nämlich einem ersten Zweig (30a), der fähig ist, den ersten Wert (t1) zu bestimmen, und einem zweiten Zweig (31a), der fähig ist, den zweiten Wert (t2) zu erkennen, eine analoge Summier-/Subtrahierschaltung (3b), die mit dem Ausgang der Messschaltung (3a) verbunden und fähig ist, die Differenz zwischen den ersten und zweiten Werten (t1, t2) auszuführen, eine analoge Mittelungs- und/oder Gleichrichtungs- und/oder Filterschaltung (3c), die mit dem Ausgang der Summier-/Subtrahierschaltung (3b) verbunden ist, und eine analoge Vergleichs- und Auslöseschaltung (3d), die mit dem Ausgang der Mittelungs- und/oder Gleichrichtungs-und/oder Filterschaltung (3c) verbunden und fähig ist, den Vergleich zwischen dieser Differenz und der Bezugsschwelle (ts) auszuführen, um das Steuersignal gemäß dem Ergebnis des Vergleichs zu senden.

11. Schutzgerät nach Anspruch 9, **dadurch gekennzeichnet, dass** die Verarbeitungs- und Steuereinheit (3) digital elektronisch konfiguriert ist, und dass sie aus einer Verarbeitungs- und Steuerschaltung auf der Basis eines Mikroprozessors oder Mikrocontrollers (3e) besteht, die fähig ist, die Anweisungen eines in einen Speicher der Verarbeitungs- und Steuereinheit (3) geladenen Verarbeitungsprogramms auszuführen, um den ersten Wert (t1) und den zweiten Wert (t2) zu messen, dann, um die Differenz zwischen den ersten und zweiten Werten (t1, t2) auszuführen und diese Differenz mit der Bezugsschwelle (ts) zu vergleichen.

12. Schutzgerät nach Anspruch 5, **dadurch gekennzeichnet, dass** die Verarbeitungs- und Steuereinheit (3) konfiguriert ist, die Frequenzanalyse durch Zerlegung des Mess- und Wechselsignals in eine Fourier-Reihe und durch Vergleich der Spannungsamplitude entsprechend einer geradzahligen Harmonischen (H2, H4, H6) mit der Bezugsschwelle (hs) zu realisieren.

## Claims

1. Method for detecting leakage or fault currents in an electrical installation using a protective device providing at least differential protection, said electrical installation being powered by a current circulating in at least two conductors of an AC or DC supply, said protective device including at least one detection, processing and control module including, on the one hand, a clamp detector (1) able to generate as output (S) an AC measurement signal and including a clamp (1a) through which said conductors pass and having a measurement winding (10a) and an AC voltage or current supply (2) able to generate an AC excitation signal to saturate the clamp (1a), where applicable said clamp detector (1) including a resistance (1b) in series with said clamp (1a), a processing and control unit (3) connected to the output (S) of the clamp detector and able to process the AC measurement signal to detect a leakage or fault current in the supply and to send a control signal as a function of the result of the processing for a disconnector or breaker control means (4) that said protective device further includes, **characterized in that** it consists in detecting asymmetry of the AC measurement signal between its positive alternation, or half-period, and its negative alternation, or half-period, generated by the presence of even harmonics (H2, H4, H6) in said AC measurement signal representative of a direct current (Idc) relating to a leakage or fault current in the supply:
- either by determining, by frequency-domain analysis of the AC measurement signal, a measurement value representative of the occurrence of even harmonics (H2, H4, H6) in said AC measurement signal and then comparing said measurement value with a reference threshold (Hs) to send the control signal according to the result of the comparison,
- or by measuring a first value (V1, t1) of a physical parameter of the AC measurement signal in its positive alternation, or half-period, and a second value (V2, t2) of said physical parameter in its negative alternation, or half-period, and then determining the difference between said first and second values (V1, t1, V2, t2) and comparing that difference with a reference threshold (Vs, ts) to send the control signal according to the result of the comparison.

2. Method according to Claim 1, **characterized in that**, for measuring the first value (V1) and the second value (V2), it consists in detecting amplitude asymmetry in the AC measurement signal by measuring the maximum amplitude of its positive alternation, or half-period, and the minimum amplitude of its negative alternation, or half-period, the first value (V1) being said maximum amplitude and the second value (V2) being said minimum amplitude.

3. Method according to Claim 1, **characterized in that** it consists in generating an excitation signal with a level of intensity creating in each positive or negative alternation, or half-period, of the AC measurement signal saturation of its maximum amplitude or minimum amplitude over a measurable duration and **in that**, for measuring the first value (t1) and the second value (t2), it consists in detecting saturation asymmetry in the AC measurement signal by measuring a first saturation duration of the maximum amplitude of its positive alternation, or half-period, and a second saturation duration of the minimum amplitude of its negative alternation, or half-period, the first value (t1) being said first saturation duration and the second value (t2) being said second saturation duration.

4. Method according to Claim 1, **characterized in that** it consists in carrying out the frequency-domain analysis by applying Fast Fourier Transform processing to the AC measurement signal and comparing the voltage amplitude corresponding to an even harmonic (H2, H4, H6) with the reference threshold (Hs).

5. Protective device providing at least differential protection enabling the detection of leakage or fault currents in an electrical installation, said electrical installation being powered by a current circulating in at least two conductors of an AC or DC supply, said protective device being suitable for implementation of the method according to any one of Claims 1 to 4 and including at least one detection, processing and control module including, on the one hand, a clamp detector (1) able to generate as output (S) an AC measurement signal and including a clamp (1a) through which said conductors pass and having a measurement winding (10a) and an AC voltage or current supply (2) able to generate an AC excitation signal to saturate the clamp (1a), where applicable said clamp detector (1) including a resistance (1b) in series with said clamp (1a), a processing and control unit (3) connected to the output (S) of the clamp detector and able to process the AC measurement signal to detect a leakage or fault current in the supply and to send a control signal as a function of the result of the processing for a disconnector or breaker control means (4) that said protective device further includes, **characterized in that** the processing and control unit (3) is configured to detect asymmetry of the AC measurement signal between its positive alternation, or half-period, and its negative alternation, or half-period, generated by the presence of even harmonics (H2, H4, H6) in said AC measurement signal representative of a direct current (Idc) relating to a leakage or fault current in the supply:
- either by determining, by frequency-domain analysis of the AC measurement signal, a measurement value representative of the occurrence of even harmonics (H2, H4, H6) in said AC measurement signal and then comparing said measurement value with a reference threshold (Hs) to send the control signal according to the result of the comparison,
- or by measuring a first value (V1, t1) of a physical parameter of the AC measurement signal in its positive alternation, or half-period, and a second value (V2, t2) of said physical parameter in its negative alternation, or half-period, and then determining the difference between said first and second values (V1, t1, V2, t2) and comparing that difference with a reference threshold (Vs, ts) to send the control signal according to the result of the comparison.

6. Protective device according to Claim 5, **characterized in that**, to be able to measure the first value (V1) and the second value (V2), the processing and control unit (3) is configured to detect amplitude asymmetry by measuring the maximum amplitude of the positive alternation, or half-period, of the AC measurement signal and the minimum amplitude of its negative alternation, or half-period, the first value (V1) being said maximum amplitude and the second value (V2) being said minimum amplitude.

7. Protective device according to Claim 6, **characterized in that** the processing and control unit (3) is electronically configured in an analog manner and **in that** it includes at least the following circuits electrically connected in series: an analog measurement circuit (3a) connected to the output (S) of the clamp detector (1) and consisting of two branches (30a, 31a) connected in parallel, namely a first branch (30a) able to measure the first value (V1) and a second branch (31a) able to measure the second value (V2), an analog summator/subtractor circuit (3b) connected to the output of said measurement circuit (3a) and able to determine the difference between said first and second values (V1, V2), an analog averaging and/or rectifier and/or filter circuit (3c) connected to the output of said summator/subtractor circuit (3b) and an analog comparator and trigger circuit (3d) connected to the output of said averaging and/or rectifier and/or filter circuit (3c) able to effect the comparison between said difference and the reference threshold (Vs) to send the control signal according to the result of the comparison.

8. Protective device according to Claim 6, **characterized in that** the processing and control unit (3) is electronically configured in a digital manner and **in that** it consists of a microprocessor or microcontroller based processing and control circuit (3e) able to execute the instructions of a processing program loaded into a memory of said processing and control unit (3) to measure the first value (V1) and the second value (V2) and then to determine the difference between said first and second values (V1, V2) and to compare that difference with the reference threshold (Vs).

9. Protective device according to Claim 5, **characterized in that** the AC voltage or current supply (2) is configured to generate an excitation signal with a level of intensity creating in each positive or negative alternation, or half-period, of the AC measurement signal saturation of its maximum or minimum amplitude over a measurable duration and **in that** the processing and control unit (3) is configured to be able to measure the first value (t1) and the second value (t2) to detect saturation asymmetry in the AC measurement signal by measuring a first saturation duration of the maximum amplitude of its positive alternation, or half-period, and a second saturation duration of the minimum amplitude of its negative alternation, or half-period, the first value (t1) being said first saturation duration and the second value (t2) being said second saturation duration.

10. Protective device according to Claim 9, **characterized in that** the processing and control unit (3) is configured in an analog manner and includes at least the following circuits electrically connected in series: an analog measurement circuit (3a) connected to the output (S) of the clamp detector (1) and consisting of two branches (30a, 31a) connected in parallel, namely a first branch (30a) able to determine the first value (t1) and a second branch (31a) able to detect the second value (t2), an analog summator/subtractor circuit (3b) connected to the output of the measurement circuit (3a) and able to establish the difference between said first and second values (t1, t2), an analog averaging and/or rectifier and/or filter circuit (3c) connected to the output of the summator/subtractor circuit (3b) and an analog comparator and trigger circuit (3d) connected to the output of the averaging and/or rectifier and/or filter circuit (3c) and able to effect the comparison between that difference and the reference threshold (ts) to send the control signal according to the result of the comparison.

11. Protective device according to Claim 9, **characterized in that** the processing and control unit (3) is electronically configured in a digital manner and **in that** it consists of a microprocessor or microcontroller based processing and control circuit (3e) able to execute the instructions of a processing program loaded into a memory of said processing and control unit (3) to measure the first value (t1) and the second value (t2) and then to establish the difference between said first and second values (t1, t2) and to compare that difference with the reference threshold (ts).

12. Protective device according to Claim 5, **characterized in that** the processing and control unit (3) is configured to carry out the frequency-domain analysis of the AC measurement signal by Fast Fourier Transform processing and comparing the voltage amplitude corresponding to an even harmonic (H2, H4, H6) with the reference threshold (hs).
